# EUROPÄISCHE PATENTSCHRIFT

(11) **EP 1 260 603 B1**
(45) Veröffentlichungstag und Bekanntmachung des Hinweises auf die Patenterteilung: **20.09.2006**
(21) Anmeldenummer: 02011204.1
(22) Anmeldetag: 21.05.2002
(51) Int. Cl.: C23C 14/00, C23C 14/35, C23C 14/02

(54) **PVD-Verfahren zur Beschichtung von Substraten mittels magnetron Kathodenzerstäubung**
PVD coating process magnetron cathodic sputtering
Procédé de revêtement PVD par pulvérisation magnétron cathodique

(30) Priorität: 21.05.2001 DE 10124749
(43) Veröffentlichungstag der Anmeldung: 27.11.2002
(73) Patentinhaber: Sheffield Hallam University, Sheffield S1 1WB (GB)
(72) Erfinder: Münz, Wolf-Dieter, Prof. Dr., Sheffield S7 1SL (GB); Ehiasarian, Arutiun P., Dr., Sheffield S2 5LZ (GB); Hovsepian, Papken Eh., Dr., Sheffield S2 5LZ (GB)
(74) Vertreter: Manitz, Finsterwald & Partner GbR

(56) Entgegenhaltungen:
- WO-A-98/40532
- DE-A- 4 206 110
- US-A- 6 033 734

## Beschreibung

Die vorliegende Erfindung betrifft ein PVD-Verfahren zur Beschichtung von Substraten, wobei nach einer Vorbehandlung eine Beschichtung mittels Kathodenzerstäubung erfolgt. Ein Verfahren dieser Art ist der US-A-6,033,734 zu entnehmen. Bei diesen Schriften erfolgt die Vorbehandlung mittels einer kathodischen Bogenentladung.

Die Kombination von kathodischer Bogenentladung und unbalanciertem Magnetron [1,2] zur Beschichtung von Werkzeugen und Bauteilen, die einem verstärkten Verschleiß ausgesetzt sind, haben sich in der industriellen Anwendung als sehr erfolgreich erwiesen [3]. Die im Dampf der kathodischen Bogenentladung erzeugten, mehrfach ionisierten Metallionen werden zur niederenergetischen Ionenimplantation benützt, typische Beschleunigungsspannung am Substrat: 1,2 kV, um ideale Bedingungen für ausgezeichnete Schichthaftung zu erzeugen. In speziellen Fällen kann sogar lokalisiertes epitaktisches Schichtwachstum erreicht werden [4]. Dabei hat sich der Beschuss der Substratoberfläche mit Cr-Ionen als besonders erfolgreich erwiesen [5], da einerseits ausgezeichnete Haftfestigkeiten erreicht werden und andererseits die als unerwünschtes Nebenprodukt auftretenden Makroteilchen ("Droplets"), sich als klein erweisen im Vergleich zu Makroteilchen, die bei der kathodischen Bogenentladung von Materialen mit niedrigerem Schmelzpunkt entstehen z.B. Ti oder TiAl [6].

Während in vielen Anwendungsbereichen der Werkzeugbeschichtung diese Makroteilchen, die sich während der Beschichtung mit dem unbalancierten Magnetron zu wesentlich vergrößerten Wachstumsdefekten weiterbilden, eine untergeordnete Rolle spielen, gewinnen sie erhebliche Bedeutung, wenn es um Korrosionsschutz geht [7] oder wenn es sich z.B. um die Trockenbearbeitung von gehärteten Formstählen (HRC - 60) handelt, wo die Schichtrauigkeit und die Porenfreiheit eine erhebliche Rolle spielen.

Bisher war im Bereich der industriellen PVD Beschichtung die Erzeugung hoher Metallionendichten verfahrensmäßig nur mit Hilfe der kathodischen Bogenentladung praktikabel.

Aufgabe der vorliegenden Erfindung ist es, ein Verfahren der eingangs genannten Art vorzusehen, bei dem Wachstumsdefekte, die auf die Bildung von Makroteilchen zurückzuführen sind, weitestgehend vermieden werden.

Um Diese Aufgabe zu lösen wird ein Verfahren der eingangs genannten Art vorgesehen, das sich dadurch auszeichnet, dass die Leistungsdichte der gepulsten Entladung bei der Vorbehandlung über 1000 W.cm⁻² liegt.

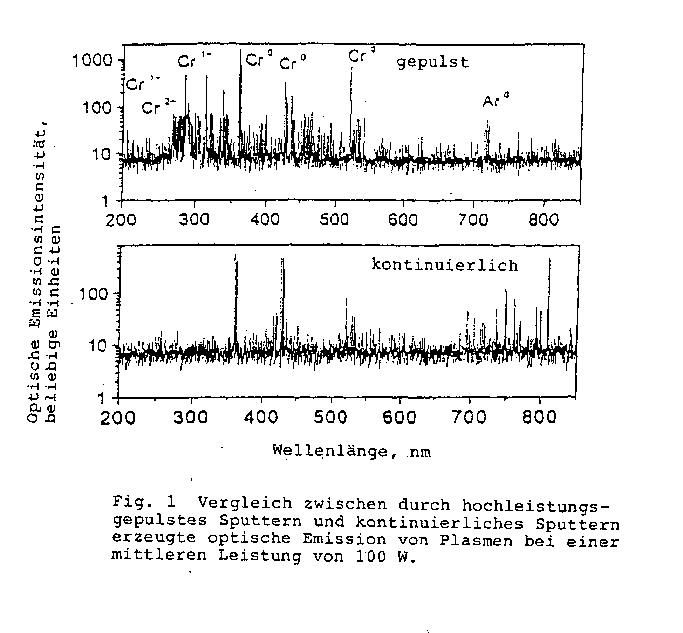

Die vorliegende Erfindung berücksichtigt, dass die magnetfeldunterstützte Impuls-Kathodenzerstäubung zusehends an Bedeutung gewinnt. Bei Anwendung von Leistungsdichten größer 1000 W.cm-2 gelingt es, Metalldämpfe zu erzeugen, in denen bis zu 60% der Metallatome ionisiert sind [8]. Dieser Wert ist vergleichbar mit Ionisierungsgraden von Metalldämpfen in der kathodischen Bogenentladung. Fig. 1 zeigt ein optisches Emissions-Spektrum eines Plasmas erzeugt in einer derartigen Impulsentladung, mit Cr als Target, mit einer Leistungsdichte von 3000 W.cm⁻², einer Spitzenspannung von 1200 V, einer Pulsdauer von 50 µS und einem Pulsintervall von 20ms. Der entscheidende Vorteil dieser Art von Metallionenerzeugung liegt darin, dass dabei keine Makroteilchen ("Droplets") entstehen und die Ausbildung von Wachstumsdefekten als Folge der Keimbildung durch Makroteilchen verhindert wird.

Erfindungsgemäß wird nun der Anteil der kathodischen Bogenentladung als Element der ABS Technik ersetzt durch eine magnetfeldgestützte Hochleistungs-ImpulsKathodenzerstäubungsquelle. Dabei bleiben die Prozesse unverändert, die sich während der Vorbehandlung am Substrat abspielen. Die negativen Beschleunigungsspannungen, notwendig zu Erzielung von Ätz-Effekten und Ionenimplantation bleiben unverändert und liegen typischerweise zwischen 0.5 und 1.5 kV. Bei der Präparation von Werkzeugstahl oder Hartmetall mit Cr-Ionen bleibt die Beschleunigungsspannung (negative Biasspannung) unverändert bei -1.2 kV [4]. Die darauf folgende Beschichtung mit dem unbalancierten Magnetron im ungepulsten Betrieb bleibt ebenso unverändert, da konventionelle Stromversorgungen eine effizientere Energieausbeute und niedrigere Gerätekosten versprechen.

Besonders bevorzugte Ausführungsformen der erfindungsgemäßen Lösung sind den Unteransprüchen zu entnehmen.

Es liegt bereits eine Reihe von Veröffentlichungen über gepulste Stromversorgungen zum Betrieb von Kathodenzerstäubungsquelle vor. Eine typische Anordnung ist in [9] beschrieben. Diese Quelle ist jedoch ausschließlich zur Beschichtung und nicht zur Vorbehandlung von Substraten entwickelt worden.

### Literatur'

[1]_H. Wesemeyer, Patent Anmeldung, Arc/Magnetron. 1989
[2] W.-D. Münz, C. Schöhnjahn, H. Paritong, I.J. Smith, Le Vide, No, 297, Vol.3/4, 2000, p. 205-223
[3] W.-D. Münz, I.J. Smith, SVC, 42^{nd} Ann. Tech. Conf. Proc., Chicago, IL, April 17-22, 1999, p. 350-356
[4] C. Schöhnjahn, L,A. Donohue, D.B. Lewis, W.-D. Münz, R.D. Twesten, I, Petrov, Journal of Vacuum Science and Technology, Vol.18, Iss.4. 2000, p. 17181723
[5] W.-D. Münz, Patentanmeldung Cr-Ätzen, 1995 (?)
[6] W.-D. Münz, I.J. Smith, D.B. Lewis, S. Creasy, Vacuum, Vol. 48, Iss. 5, 1997, p, 473-481
[7] H.W. Wang, M.M. Stark, S.B. Lyon, P. Hovsepian, W.-D. ***Münz. Surf, Coat.*** Technol., 126, 2000, p. 279-287
[8] A.P. Ehiasarian, K.M. Macak, R. New, W.-D. Münz, U. Helmersson, paper to be presented at the 48^{th} International Symposium, IUVSTA 15^{th} International Vacuum Congress, Oct/Nov 2001, San Francisco, CA, USA
(9] V. Kouznetsov, PCT Anmeldung W098/40532. EP 1038045

## Patentansprüche

1. PVD-Verfahren zur Beschichtung von Substraten, wobei nach einer Vorbehandlung eine Beschichtung mittels Kathodenzerstäubung erfolgt, **dadurch gekennzeichnet, dass** das Substrat im Dampf einer gepulsten magnetfeldgestützten Kathodenzerstäubung vorbehandelt wird, dass während der Vorbehandlung zur Magnetfeldunterstützung eine Magnetfeldanordnung nach Art der Magnetronkathode benützt wird mit einer Stärke der Horizontalkomponente vor dem Target von 100 bis 1500 Gauss und dass die Leistungsdichte der gepulsten Entladung bei der Vorbehandlung über 1000 W.cm⁻² liegt.

2. Verfahren nach Anspruch 1, **dadurch gekennzeichnet dass** die Leistungsdichte im Bereich von 2000 bis 3000 W.cm⁻² liegt.

3. Verfahren nach Anspruch 1, **dadurch gekennzeichnet dass** die Pulsdauer zwischen 10 und 1000 µs liegt und dass das Pulsintervall zwischen 0.2 ms und 1000 s beträgt.

4. Verfahren nach Anspruch 1, **dadurch gekennzeichnet dass** die Pulsdauer bei 50 µs und das Pulsintervall bei 20 ms liegt.

5. Verfahren nach Anspruch 1, **dadurch gekennzeichnet, dass** die Entladung nach Art der Magnetronentladung über die Kathodenfläche verteilt ist und dabei mindest 50% der Fläche ausfüllt.

6. Verfahren nach Anspruch 5, **dadurch gekennzeichnet, dass** sich die Entladung über 70-90% der Kathodenfläche ausdehnt.

7. Verfahren nach Anspruch 1, **dadurch gekennzeichnet, dass** die durchschnittliche gepulste Entladungsstromdichte kleiner als 10 A.cm⁻² ist.

8. Verfahren nach Anspruch 1, **dadurch gekennzeichnet, dass** die lokale maximale gepulste Entladungsstromdichte unter 100 A.cm⁻² liegt.

9. Verfahren nach Anspruch 1, **dadurch gekennzeichnet, dass** die erzeugten Pulse eine Spitzenspannung von 0.5 bis 2.5 kV aufweisen.

10. Verfahren nach Anspruch 1, **dadurch gekennzeichnet, dass** die Vorbehandlung mit magnetfeldunterstützter Kathodenzerstäubung in nichtreaktiver Atmosphäre, z.B. Ne. Ar, Kr, oder Xe mit Targets aus Cr, V, Ti, Zr, Mo, W, Nb, Ta erfolgt.

11. Verfahren nach Anspruch 1, **dadurch gekennzeichnet, dass** die Vorbehandlung mit Ar in einem Druckbereich von 10⁻⁵ bis 10⁻¹ bar stattfindet.

12. Verfahren nach Anspruch 1, **dadurch gekennzeichnet, dass** die Vorbehandlung mit Ar bei 10⁻³ mbar stattfindet.

13. Verfahren nach einem der Ansprüche 1 bis 12, **dadurch gekennzeichnet, dass** die Substrate während der Vorbehandlung im Bereich von 0.5 bis 1.5 kV negativ vorgespannt sind und zwar derart, dass ein Ätz - bzw. Reinigungsprozess und gleichzeitig ein Ionenimplantationsprozess ausgelöst wird (ABS Technik).

14. Verfahren nach Anspruch 13, **dadurch gekennzeichnet, dass** die negative Vorspannung gepulst ist mit Pulsbreiten 2 µs bis 20 ms und einem Pulsintervall von ebenfalls 2 µs bis 20 ms.

15. Verfahren nach Anspruch 1, **dadurch gekennzeichnet, dass** die Beschichtung mit Kathodenzerstäubung aus den Nitriden TiN, ZrN, Ti-A1N, TiZrN, TiWN, TiNbN, TiTaN, TiBN oder aus den Karbonitriden TiCN, ZrCN, TiAICN, TiZrCN, TiVCN, TiNbCN, TiTaCN, TiBCN besteht.

16. Verfahren nach Anspruch 15, **dadurch gekennzeichnet, dass** die Beschichtung 0.1 bis 5 at% der seltenen Erden Sc, Y, La, Ce enthält.

17. Verfahren nach Anspruch 1, **dadurch gekennzeichnet, dass** die Beschichtungen aus feinen (nanoscale) Viellagenschichten bestehen mit einer Periodizität von 1 bis 10 nm aus der Gruppe TiN/TiAlN, TiN/VN, TiN/NbN, TiN/TaN, TiN/ZrN, TiAlN/CrN, TiAlN/ZrN, TiAlN/VN, CrN/NbN, CrN/TaN, CrN/TiN, Cr/C, Ti/C, Zr/C, V/C, Nb/C, Ta/C.

18. Verfahren nach Anspruch 16, **dadurch gekennzeichnet, dass** eine der angeführten Einzelschichten 0.1 bis 5 at% der seltenen Erden Sc, Y, La, Ce enthält.

19. Verfahren nach Anspruch 16, **dadurch gekennzeichnet, dass** beide der angeführten Einzelschichten 0.1 bis 5 at% der seltenen Erden Sc, Y, La oder Ce enthalten.

20. Verfahren nach Anspruch 1, **dadurch gekennzeichnet, dass** die bei der Beschichtung angewandte Kathodenzerstäubung nach Art des unbalancierten Magnetrons erfolgt.

21. Verfahren nach Anspruch 1, **dadurch gekennzeichnet, dass** für die Vorbehandlung und Beschichtung identische Kathoden und identische Magnetfeldanordnungen benützt werden.

22. Verfahren nach Anspruch 21, **dadurch gekennzeichnet, dass** individuelle Anpassungen der Magnetfeldstärke zur Optimierung der Vorbehandlung und Beschichtung durch Einstellung des Abstands der Magnetanordnung von der Targetoberfläche bewerkstelligt wird.

## Claims

1. A PVD method for the coating of substrates, wherein a coating takes place by means of cathode sputtering after a pre-treatment, **characterised in that** the substrate is pre-treated in the vapour of a pulsed cathode sputtering process assisted by a magnetic field; **in that** a magnetic field arrangement in the manner of a magnetron cathode is used for the magnetic field assistance during the pre-treatment and has a strength of the horizontal component in front of the target of 100 to 1500 Gauss; and **in that** the power density of the pulsed discharge in the pre-treatment is more than 1000 W.cm⁻².

2. A method in accordance with claim 1, **characterised in that** the power density lies in the range from 2000 to 3000 W.cm⁻².

3. A method in accordance with claim 1, **characterised in that** the pulse duration lies between 10 and 1000 µs; and **in that** the pulse interval amounts to between 0.2 ms and 1000 s.

4. A method in accordance with claim 1, **characterised in that** the pulse duration lies at 50 µs and the pulse interval at 20 ms.

5. A method in accordance with claim 1, **characterised in that** the discharge is distributed over the cathode surface in the manner of a magnetron discharge and covers at least 50% of the surface in this process.

6. A method in accordance with claim 5, **characterised in that** the discharge extends over 70 - 90% of the cathode surface.

7. A method in accordance with claim 1, **characterised in that** the average pulsed discharge current density is smaller than 10 A.cm⁻².

8. A method in accordance with claim 1, **characterised in that** the local maximum pulsed discharge current density lies below 100 A.cm⁻².

9. A method in accordance with claim 1, **characterised in that** the pulses generated have a peak voltage from 0.5 to 2.5 kV.

10. A method in accordance with claim 1, **characterised in that** the pre-treatment takes place with cathode sputtering assisted by a magnetic field in a non-reactive atmosphere, e.g. Ne, Ar, Kr or Xe, with targets of Cr, V, Ti, Zr, Mo, W, Nb, Ta.

11. A method in accordance with claim 1, **characterised in that** the pre-treatment takes place with Ar in a pressure range from 10⁻⁵ to 10⁻¹ bar.

12. A method in accordance with claim 1, **characterised in that** pre-treatment takes place with Ar at 10⁻³ mbar.

13. A method in accordance with any one of the claims 1 to 12, **characterised in that** the substrates are negatively biased during the pre-treatment in the range from 0.5 to 1.5 kV, and indeed such that an etching or cleaning process, and simultaneously an ion implanting process is triggered (ABS technique).

14. A method in accordance with claim 13, **characterised in that** the negative bias is pulsed with pulse widths 2 µs to 20 ms and a pulse interval of likewise 2 µs to 20 ms.

15. A method in accordance with claim 1, **characterised in that** the coating consists of cathode sputtering of the nitrides TiN, ZrN, TiAlN, TiZrN, TiWN, TiNbN, TiTaN, TiBN or of the carbon nitries TiCN, ZrCN, TiAlCN, TiZrCN, TiVCN, TiNbCN, TiTaCN, TiBCN.

16. A method in accordance with claim 15, **characterised in that** the coating contains 0.1 to 5 at% of the rare earths Sc, Y, La, Ce.

17. A method in accordance with claim 1, **characterised in that** the coatings consist of fine (nanoscale) multilayer films having a periodicity from 1 to 10 nm from the group TiN/TiAlN, TiN/VN, TiN/NbN, TiN/TaN, TiN/ZrN, TiAlN/CrN, TiAlN/ZrN, TiAlN/ZrN, TiAlN/VN, CrN/NbN, CrN/TaN, CrN/TiN, Cr/C, Ti/C, Zr/C, V/C, Nb/C, Ta/C.

18. A method in accordance with claim 16, **characterised in that** one of the individual layers listed contains 0.1 to 5 at% of the rare earths Sc, Y, La, Ce.

19. A method in accordance with claim 16, **characterised in that** both of the individual layers listed contain 0.1 to 5 at% of the rare earths Sc, Y, La or Ce.

20. A method in accordance with claim 1, **characterised in that** the cathode sputtering used in the coating takes place in the manner of the imbalanced magnetron.

21. A method in accordance with claim 1, **characterised in that** identical cathodes and identical magnetic field arrangements are used for the pre-treatment and coating.

22. A method in accordance with claim 21, **characterised in that** individual adaptations of the magnetic field intensity are effected for the optimisation of the pre-treatment and coating by setting the spacing of the magnet arrangement from the target surface.

## Revendications

1. Procédé de revêtement de substrats par dépôt physique en phase vapeur (PVD) dans lequel on effectue, après un prétraitement, un revêtement par pulvérisation cathodique, **caractérisé en ce que** l'on traite préalablement le substrat dans la vapeur d'une pulvérisation cathodique pulsée assistée par champ magnétique, **en ce que** l'on utilise pendant le prétraitement, pour assurer l'assistance par champ magnétique, un dispositif de production de champ magnétique de type cathode de magnétron avec une intensité de la composante horizontale devant la cible de 100 à 1 500 gauss, et **en ce que** la puissance volumique de la décharge par impulsions lors du prétraitement est supérieure à 1 000 W.cm⁻².

2. Procédé selon la revendication 1, **caractérisé en ce que** la puissance volumique est comprise dans une fourchette de 2 000 à 3 000 W.cm⁻².

3. Procédé selon la revendication 1, **caractérisé en ce que** la durée d'impulsion est comprise entre 10 et 1 000 µs et **en ce que** l'intervalle entre impulsions fait entre 0,2 ms et 1 000 s.

4. Procédé selon la revendication 1, **caractérisé en ce que** la durée d'impulsion est d'environ 50 µs et l'intervalle entre impulsions d'environ 20 ms.

5. Procédé selon la revendication 1, **caractérisé en ce que** la décharge, de type décharge de magnétron, est répartie sur la surface de cathode et, ce faisant, occupe au minimum 50 % de la surface.

6. Procédé selon la revendication 5, **caractérisé en ce que** la décharge s'étend sur 70 à 90 % de la surface de cathode.

7. Procédé selon la revendication 1, **caractérisé en ce que** la densité moyenne de courant de décharge par impulsions est inférieure à 10 A.cm⁻².

8. Procédé selon la revendication 1, **caractérisé en ce que** la densité maximale locale de courant de décharge par impulsions est inférieure à 100 A.cm⁻².

9. Procédé selon la revendication 1, **caractérisé en ce que** les impulsions produites présentent une tension de crête de 0,5 à 2,5 kV.

10. Procédé selon la revendication 1, **caractérisé en ce que** le prétraitement par pulvérisation cathodique assistée par champ magnétique a lieu dans une atmosphère non réactive, par exemple dans du néon (Ne), de l'argon (Ar), du krypton (Kr) ou du xénon (Xe), avec des cibles faites de chrome (Cr), de vanadium (V), de titane (Ti), de zirconium (Zr), de molybdène (Mo), de tungstène (W), de niobium (Nb), de tantale (Ta).

11. Procédé selon la revendication 1, **caractérisé en ce que** le prétraitement à l'argon (Ar) a lieu dans une fourchette de pression allant de 10⁻⁵ à 10⁻¹ bar.

12. Procédé selon la revendication 1, **caractérisé en ce que** le prétraitement à l'argon (Ar) a lieu à 10⁻³ mbar.

13. Procédé selon l'une des revendications 1 à 12, **caractérisé en ce que,** pendant le prétraitement, les substrats sont polarisés négativement dans une fourchette de 0,5 à 1,5 kV, et ce de telle sorte qu'un processus de décapage ou de nettoyage et, en même temps, un processus d'implantation ionique se déclenchent (technique ABS).

14. Procédé selon la revendication 13, **caractérisé en ce que** la polarisation négative est pulsée avec des largeurs d'impulsion de 2 µs à 20 ms et un intervalle entre impulsions également de 2 µs à 20 ms.

15. Procédé selon la revendication 1, **caractérisé en ce que** le revêtement par pulvérisation cathodique se compose de nitrures TiN, ZrN, TiAlN, TiZrN, TiWN, TiNbN, TiTaN, TiBN ou de carbonitrures TiCN, ZrCN, TiAlCN, TiZrCN, TiVCN, TiNbCN, TiTaCN, TiBCN.

16. Procédé selon la revendication 15, **caractérisé en ce que** le revêtement contient 0,1 à 5 %a des terres rares scandium (Sc), yttrium (Y), lanthane (La), cérium (Ce).

17. Procédé selon la revendication 1, **caractérisé en ce que** les revêtements se composent de fines couches multistrates (nanométriques), ayant une périodicité de 1 à 10 nm, issues du groupe TiN/TiAlN, TiN/VN, TiN/NbN, TiN/TaN, TiN/ZrN, TiAlN/CrN, TiAlN/ZrN, TiAlN/VN, CrN/NbN, CrN/TaN, CrN/TiN, Cr/C, Ti/C, Zr/C, V/C, Nb/C, Ta/C.

18. Procédé selon la revendication 16, **caractérisé en ce que** l'une des couches individuelles citées contient 0,1 à 5 %a des terres rares scandium (Sc), yttrium (Y), lanthane (La), cérium (Ce).

19. Procédé selon la revendication 16, **caractérisé en ce que** les deux couches individuelles citées contiennent 0,1 à 5 %a des terres rares scandium (Sc), yttrium (Y), lanthane (La), cérium (Ce).

20. Procédé selon la revendication 1, **caractérisé en ce que** la pulvérisation cathodique utilisée lors du revêtement a lieu par la méthode du magnétron asymétrique.

21. Procédé selon la revendication 1, **caractérisé en ce que** l'on utilise des cathodes identiques et des dispositifs de production de champ magnétique identiques pour le prétraitement et pour le revêtement.

22. Procédé selon la revendication 21, **caractérisé en ce que** des adaptations individuelles de l'intensité de champ magnétique en vue d'optimiser le prétraitement et le revêtement sont effectuées par réglage de la distance entre le dispositif magnétique et la surface de cible.
